# EUROPEAN PATENT APPLICATION

(11) **EP 1 936 674 A2**
(43) Date of publication of application: **25.06.2008**
(21) Application number: 07123952.9
(22) Date of filing: 21.12.2007
(51) Int. Cl.: H01L 21/3105, H01L 21/321, C09G 1/02

(54) **Method and slurry for tuning low-k versus copper removal rates during chemical mechanical polishing**

(30) Priority: 21.12.2006 US 643519
(71) Applicant: DuPont AirProducts NanoMaterials Limited Liability, Tempe, AZ 85282 (US)
(72) Inventor: Siddiqui, Junaid Ahmed, Richmond, AZ 23234 (US); McConnell, Rachel Dianne, Mesa, AZ 85204 (US); Usmani, Saifi, Phoenix, AZ 85045 (US)
(74) Representative: Muir, Benjamin M. J.

(57) **Abstract**

A composition and associated method for the chemical mechanical planarization (CMP) of metal substrates on semiconductor wafers are described. The composition contains a nonionic fluorocarbon surfactant and a per-type oxidizer (e.g., hydrogen peroxide). The composition and associated method are effective in controlling removal rates of low-k films during copper CMP and provide for tune-ability in removal rates of low-k films in relation to removal rates of copper, tantalum, and oxide films.

## Description

### BACKGROUND OF THE INVENTION

This invention relates generally to the chemical-mechanical planarization (CMP) of metal substrates (e.g., copper substrates) on semiconductor wafers and slurry compositions therefor. In particular, the present invention relates to a CMP slurry composition that is effective for use in copper CMP which comprises a non-ionic fluorocarbon surfactant and hydrogen peroxide for controlling the removal rates of certain low-k films during chemical mechanical planarization of copper.

There are a large number of materials used in the manufacture of integrated circuits such as a semiconductor wafer. The materials generally fall into three categories - dielectric material, adhesion and/or barrier layers, and conductive layers. The use of the various substrates, e.g., dielectric material such as TEOS (Tetraethyl Orthosilicate), PETEOS (dielectric silicon oxide layer formed by plasma enhanced deposition of tetraethoxy silane), and low-k dielectric materials such as Black Diamond; barrier/adhesion layers such as tantalum, titanium, tantalum nitride, and tantalum nitride; and conductive layers such as copper, aluminum, tungsten, and noble metals is known in the industry.

This invention pertains to slurries used for copper. A common manufacturing process uses copper in a damascene type structure. During the manufacturing process, a substantial excess of copper is deposited over the surface of a wafer. Typically, a multi-step copper CMP process is employed involving the initial removal and planarization of the copper overburden, referred to as a step 1 copper CMP process, followed by a barrier layer CMP process. Therefore, during much of the step 1 copper CMP process copper is the only substrate material exposed to the CMP slurry, and manufacturers utilize copper slurries to obtain very high copper removal rates. However, when other materials begin to appear or are about to appear on the substrate surface, manufacturers switch to barrier slurries. The barrier layer CMP process is frequently referred to as a barrier or step 2 copper CMP process. A step 2 copper CMP process involves using at least one added slurry, used after the step 1 polishing, to provide a softer landing.

Previously, it was believed that the removal rate of the copper and the adhesion-promoting layer and/or the diffusion barrier layer must both greatly exceed the removal rate of dielectric so that polishing effectively stops when elevated portions of the dielectric are exposed. The ratio of the removal rate of copper to the removal rate of dielectric base is called the "selectivity" for removal of copper in relation to dielectric during CMP processing of substrates comprised of copper, tantalum and dielectric material. The ratio of the removal rate of tantalum to the removal rate of dielectric base is called the "selectivity" for removal of tantalum in relation to dielectric during CMP processing. When CMP slurries with high selectivity for removal of copper and tantalum in relation to dielectric are used, the copper layers are easily over-polished creating a depression or "dishing" effect in the copper vias and trenches. Another feature distortion that is unsuitable for semiconductor manufacturing is called "erosion." Erosion is the topography difference between a field of dielectric and a dense array of copper vias or trenches. In CMP, the materials in the dense array maybe removed or eroded at a faster rate than the surrounding field of dielectric. This causes a topography difference between the field of dielectric and the dense copper array.

During chemical mechanical planarization of copper, defects such as deposition of undesired particles and surface roughness can result. Some specific defect types include haze, pits, scratches, mounds, dimples, and stacking faults. A number of slurry composition systems for CMP of copper for reducing defectivity have been disclosed using different types of abrasive particles.

Due to different IC (integrated circuit) chip design and manufacturing processes, different customers need different removal rates of the various substrate materials. When polishing with a barrier slurry, generally, three materials will be present for at least a portion of the polishing time of such a structure - a barrier material such as tantalum and/or TaN, copper, and a base dielectric material such as PETEOS. More recent manufacturing processes may also have one or more low-k layers disposed on the surface to be polished.

The associated methods of this invention entail use of the aforementioned composition (as disclosed supra) for chemical mechanical planarization of substrates comprised of metals and dielectric materials. In the methods, a substrate (e.g., a wafer) is placed face-down on a polishing pad which is fixedly attached to a rotatable platen of a CMP polisher. In this manner, the substrate to be polished and planarized is placed in direct contact with the polishing pad (understanding that there is a liquid or slurry layer disposed there between). A wafer carrier system or polishing head is used to hold the substrate in place and to apply a downward pressure against the backside of the substrate during CMP processing while the platen and the substrate are rotated. The polishing composition (slurry) is applied (usually continuously) on the pad during CMP processing to effect the removal of material to planarize the substrate. Of course, this invention also encompasses the known variant where some or all of the abrasive is disposed on the face of the polishing pad.

The slurry composition and associated methods of this invention are effective for CMP of a wide variety of substrates, including certain dielectric materials having dielectric constants less than 3.3 (low-k materials). Hydrophobic low-k dielectric films such as Black Diamond® are commonly used in IC chip to reduce "cross-talk" between conductor and insulator in electronic devices. Representative low-k materials and deposition methods for these materials are summarized below.

| Vendor | Trade Name | Deposition Method | Material |
|---|---|---|---|
| Air Products and Chemicals | MesoElk^{®} | Spin-on | Hybrid organic-inorganic |
| Applied Materials | Black Diamond^{®} 2^{nd} gen. Black Diamond^{®} (dielectric constant of less than 2.4). chemical vapor deposition Carbon-doped oxide | | |
| Dow Chemical | SiLK™, Porous SiLK™ | Spin-on | Organic polymer |
| Honeywell Elec. Mat. | NANOGLASS^{®} E | Spin-on | Inorganic oxide-like |
| Novellus Systems | CORAL^{®} | Plasma enhanced CVD | Carbon-doped oxide |

This slurry is at least suitable for use on low-k materials that include carbon-doped oxide, e.g., Black Diamond® and CORAL®. Newer low-k materials entering the market include the next generation of Black Diamond®, which we understand is a carbon-doped oxide having a dielectric constant of less than 2.4.

Manufacturers want to store and utilize one type of barrier slurry. Generally, during chemical mechanical planarization manufacturers want removal rates of low-k materials such as Black Diamond® to range between 50 Å/min to 800 Å/min. Tunability, that is, the ability to at least partially change the relative polishing rates of one or more of PETEOS, low-k dielectric materials, copper, and a barrier material relative to the removal rates of the other materials is needed. A barrier slurry that is independently tunable for copper, barrier materials, PETEOS, and for each of the low-k materials is highly desired. Black Diamond® is one of the low-k materials extensively used by industry, and it has a dielectric constant of about 2.8. CORAL® has similar properties, and the components found to be effective for Black Diamond® are expected to be useful for CORAL®.

### BRIEF SUMMARY OF THE INVENTION

We have surprisingly discovered that non-ionic fluorinated surfactants, of which Zonyl FSN® is a preferred example, when used in a polishing slurry having a per-type oxidizer, of which hydrogen peroxide is preferred, provide a mechanism to very effectively tune Black Diamond® and similar low-k materials such as CORAL®. Advantageously, use of non-ionic fluorinated surfactants in slurry formulations to tune the removal rate of various low-k materials and especially including Black Diamond®, depending upon the concentration of the additive, does not significantly affect the removal rates of a barrier layer (e.g., tantalum), copper, and oxide (e.g., PETEOS). By not significantly affect the removal rate of copper, we mean the removal rate of copper does not change by over 50% compared to the removal rate in the absence of the non-ionic fluorosurfactant, or changes by less than 200 Å/min, whichever is lower. By not significantly affecting the removal rate of barrier layer material, we mean the removal rate of barrier layer material does not change by over 50% compared to the removal rate of barrier layer material in the absence of the non-ionic fluorosurfactant, or changes by less than 200 Å/min, whichever is lower. By not significantly affect the removal rate of oxide, we mean the removal rate of oxide changes by less than 200 Å/min compared to the removal rate of oxide in the absence of the non-ionic fluorosurfactant. More specifically, the invention includes a method of chemical mechanical polishing utilizing a slurry comprising a non-ionic fluorocarbon surfactant and hydrogen peroxide for controlling the removal rates of certain low-k films (especially carbon-doped oxides) during chemical mechanical planarization of copper. Alternatively, the invention includes a method of chemical mechanical polishing utilizing a slurry comprising an anionic phosphate fluorocarbon surfactant and hydrogen peroxide, alone or in combination with a non-ionic fluorocarbon surfactant, for controlling the removal rates of certain low-k films (especially carbon-doped oxides) during chemical mechanical planarization of copper.

In another aspect, the invention includes a copper step 2 slurry or barrier slurry that is tunable for each of carbon-doped oxide low-k materials, copper, the barrier material, and silica. Some manufacturers want a slurry where the removal rates of barrier material, silica (PETEOS or TEOS), and carbon-doped silica low-k material (e.g., Black Diamond®) are each within 30% of the removal rate of copper, where the removal rate is measured at either 1 or 2 psi (6.9 and 13.8 kPa) pressure as higher pressures can result in damaged substrates. Other manufacturers specify removal rates for each component. The preferred slurry of this invention is tunable for all components, where the variables are amount of hydrogen peroxide, amount of non-ionic fluorosurfactant (tunes low-k material removal rates and reduces defects), amount of anionic phosphate fluorocarbon surfactant (tunes low-k material removal rates), benzenesulfonic acid (increases barrier material removal rate while reducing copper removal rates), amount of abrasive, and pH allow the removal rates of each of silica, carbon-doped oxide low-k material, copper, and barrier material (usually comprising tantalum) to be independently tuned (specified) between a removal rate of 50 to 400 Å/min. For example, if a substrate surface comprises silica, carbon-doped silica oxide low-k material, Ta, and Cu, and the polishing composition comprises colloidal silica, benzenesulfonic acid, between 250 ppm and 2000 ppm of the non-ionic fluorinated surfactant and hydrogen peroxide, then the manufacturer may specify the removal rate of copper is between 50 and 150 Å/min, the removal rate of silica is between 150 and 250 Å/min, the removal rate of tantalum is 200 to 400 Å/min, and the removal rate of carbon-doped low-k material is between 200 and 400 Å/min, where each removal rate is measured at 2 psi (13.8 kPa) polishing pressure.

In one aspect, the invention therefore relates to a process for (step 2) polishing copper, the barrier layer, and a low-k dielectric material, in particular Black Diamond@, next generation Black Diamond®, or CORAL®, where the process comprises movably contacting the face of the substrate to be polished with an abrasive and a liquid comprising a per-type oxidizer (preferably hydrogen peroxide) and a non-ionic fluorosurfactant. The invention also encompasses the use of a liquid or slurry to polish substrates comprising copper and a low-k dielectric material, where some or all of the abrasive is suspended in the liquid. Alternatively or additionally, the slurry may comprise an anionic phosphate fluorosurfactant, though the effects of such a surfactant are very different than the effects observed with non-ionic fluorosurfactant.

Suitable oxidizing agents include, for example, one or more per-compounds, which comprise at least one peroxy group (-O-O-). Suitable per-compounds include, for example, peroxides (e.g., hydrogen peroxide and urea hydrogen peroxide), persulfates (e.g., monopersulfates and dipersulfates), percarbonates, perchlorates, perbromates, periodates, and acids thereof, and mixtures thereof, and the like, peroxyacids (e.g., peracetic acid, perbenzoic acid, m-chloroperbenzoic acid, salts thereof), mixtures thereof, and the like. Preferred oxidizing agents include, for example, hydrogen peroxide, urea-hydrogen peroxide, sodium or potassium peroxide, benzyl peroxide, di-t-butyl peroxide, peracetic acid, monopersulfuric acid, dipersulfuric acid, iodic acid, and salts thereof, and mixtures thereof. Hydrogen peroxide (H₂O₂) is the most preferred oxidizing agent. The per-type oxidizer is typically present in an amount between 0.1 % and 10%, for example between 0.5% and 9%, and is advantageously between 1 % and 5% by weight. When used, the preferred concentration of the H₂O₂ is from 0.5% to 7%, for example between 0.5% and 3%.

Advantageously the slurry composition also comprises an aromatic sulfonic acid, most preferably benzesulfonic acid, in an amount between 0.05% to 5%, preferably between 0.2% to 3%, for example between 0.5% to 1.5% by weight. Aromatic sulfonic acids can have two functions. First, they can act as a second oxidizer and greatly increase barrier layer removal rates, for example Ta, TaN, Ti, TiN, and the like, most particularly Ta. Benzesulfonic acid, in the polishing compositions of the current invention, is believed to act synergistically with the hydrogen peroxide and provide the greatest barrier layer removal rates if present in an amount between 1% and 1.5% by weight, say 1.2% or 1.3% in weight. Lesser amounts can be used to reduce (tune) the barrier layer removal rates. Additionally, aromatic sulfonic acids such as benzenesulfonic acid are believed to form insoluble precipitates with copper, and thus reduce copper removal rates.

The non-ionic fluorosurfactant can have any of a number of structures. A typical structure can be represented by the formula A-B-D, where: "A" is a hydrophilic segment formed from a chain of carbon atoms and optionally one or more of O, N, or S atoms (preferably O) inserted within said chain; "B" is an optional hydrophobic segment formed from a chain of carbon atoms and optionally one or more of O, N, or S atoms (preferably O) inserted within said chain, but with a higher percentage of C atoms than is present in the "A" segment; and "D" is a carbon chain having a plurality of fluorine atoms replacing hydrogen and being bonded thereto. The "B" segment can be deleted if the "D" segment provides sufficient hydrophobicity for the molecule to function as a surfactant. The above structures encompasses block copolymers, that is, a surfactant comprising blocks of "D" segments and/or one or more "A" and/or "B" segments. An exemplary block copolymer may be represented by A-B-A-D or A-B-A-B-D where the "A" and "B" segments need not be identical. The invention also encompasses use of slurries where the non-ionic fluorosurfactant is polydisperse in molecular weight and/or composition. Also, the above formula encompasses other combinations of segments.

The preferred class of non-ionic fluorinated surfactants useful in this invention include those having a structure as follows:

(R_{f})(R₁O)ₓR_{b}

where:
R_{f} = X(CX₂)y, where X is F or any combination of H and F provided that at least a portion of the X atoms in the surfactant are F, and where y is between 1 to 18;
R₁O is independently CH₂CH₂O-, CH₂CH₂CH₂O - , or CₐH₂ₐO- , where the number of carbon atoms "a" is between 3 and 8, or any combination of the above, and where x = 1 to 25 or 26; and
R_{b} is H or a straight, branched, or ringed alkane, alkene, alkyne, alcohol, or fatty acid having between 1 and 18 carbon atoms.

The above structures encompasses (and prefers) block copolymers, that is, a surfactant comprising blocks of one or more (R₁O)ₓ segments and/or of (CX₂)y segments. The invention also encompasses use of slurries where the non-ionic fluorosurfactant is polydisperse in molecular weight and/or composition.

Preferably at least half, more preferably at least three quarters, of the X atoms in the R_{f} segment are F. Preferably the average y in the R_{f} segment is between 2 and 18, preferably 3 and 12, such as between 6 and 9.

Preferably, R₁O is independently CH₂CH₂O-, CH₂CH₂CH₂O - , or mixture thereof, more preferably CH₂CH₂O-. A block of CH₂CH₂O-segments will form a hydrophilic section "A", while a block of CH₂CH₂CH₂O - and/or CₐH₂ₐO- segments (where "a" is 3 or more) will form a hydrophobic section "B." One or more of the O atoms can optionally be replaced by a N or S, but preferably more than 70%, more preferably more than 90%, and most preferably all of the bridging atoms are O. It is useful to have blocks of hydrophilic polyoxyethylene where x is at least 4. Preferably the average x is between 5 to 20, such as between 8 and 15. For use on Black Diamond® and CORAL, preferably R₁O is CH₂CH₂O-. For use on second generation low-k materials having a dielectric constant below 2.4, blocks of polyoxypropylene advantageously can be included with the blocks of hydrophilic polyoxyethylene to increase the hydrophobicity of the non-ionic fluorosurfactant.

Further, these fluorinated non-ionic surfactants will be useful for tuning second generation Black Diamond® having a dielectric constant of less than 2.5, more typically less than 2.4, such as about 2.3. For use on Black Diamond® and CORAL, preferably R_{b} is H or a straight, branched, or ringed alkane, alkene, alkyne, or alcohol having between 1 and 6 carbon atoms. Preferably R_{b} is H. Because the second generation Black Diamond® is more hydrophobic than Black Diamond®, the inclusion of at least one non-polar segment - e.g., an alkane moiety having between 6 and 18 carbon atoms - should increase the effectiveness of the non-ionic fluorinated surfactant. For use on second generation low-k materials having a dielectric constant below 2.5, preferably R_{b} is H or a straight, branched, or ringed alkane, alkene, alkyne, alcohol, or fatty acid having between 6 and 18 carbon atoms. Alternately or additionally, for use on second generation low-k materials having a dielectric constant below 2.5, preferably (R₁O)ₓ includes at least one block of CH₂CH₂CH₂O- and/or CₐH₂ₐO- segments.

Useful concentrations of the non-ionic fluorinated surfactants in the polishing slurry range from 10 ppm to 5000 ppm, but the preferred range is between 20 ppm and 2000 ppm, for example between 50 and 1000 ppm by weight based on the weight of the slurry.

Without being bound by theory, we believe the very high effect of very small amounts of the non-ionic fluorinated surfactants of this invention result from an interaction of the non-ionic fluorinated surfactants with the per-type oxidizer to form quasi-stable active free radical species of the non-ionic fluorinated surfactants of this invention are produced as a result of chemical reaction between the non-ionic fluorinated surfactants and H₂O₂. By quasi-stable we mean the free radical can exist in solution for an amount of time sufficient for at least some of the free radicals produced to contact the substrate being polished. The quasi-stable non-ionic fluorinated surfactant free radicals react with and weakly bind to Black Diamond, hence controlling the removal rates of Black Diamond® at very low concentrations.

The abrasive can be any suitable abrasive, e.g., fumed or colloidal silica, alumina, gamma alumina, ceria, abrasive plastic or polymeric particles, spinels, zinc oxide, hybrid organic/inorganic particles (e.g., silicone particles such as Tospearl^{™}, Toshiba Silicone Co., Ltd., Tokyo, Japan) or mixtures thereof. The weight average abrasive particle size is between 10 nanometers and 0.5 microns, preferably between 50 nanometers and 200 nanometers. The abrasive is present in the slurry in a concentration of 0.2% to 25%, typically 1% to 10%, preferably 4% to 7% of the total weight of the slurry.

The preferred abrasive is colloidal silica. The colloidal silica can comprise a stabilizer containing Al, B, or both on the surface thereof. For example, the colloidal silica can be borate-surface-modified colloidal silica such as is described in U.S. Patent 6,743,267, or aluminum-acetate-surface-modified silica such as is described in U.S. Patent 6,893,476.

It is particularly beneficial to use colloidal silica that is substantially free of soluble polymeric silicates, such as is described in U.S. Patent 6,979,252. The soluble polymeric silicates present in colloidal silicas are typically crosslinked polysilicates with negative silicate anionic structures stabilized with positive counter ions (e.g., potassium ions). The amount of these materials is pH dependent. As the pH increases above 10, the amount of these materials also increases. The pH of commercially available colloidal silica is usually between 10.2 to 10.8 and over this range, the solubility of polysilicate is between approximately 0.2 to 1 weight %. Additionally, the soluble silicates during an elevated temperature particle growth reaction in a colloidal silica reactor, or upon aging of the colloidal silica, can crosslink and form gels which can remain soluble for varying periods and not be filterable. Even after fine filtration (0.5 micron filters) of colloidal silica slurries, these soluble polymeric silicates/gels are present. Upon aging, polysilicate gels in a ammonium-, sodium- or potassium-stabilized colloidal silica dispersion can also bridge with silica nanoparticles via cation ion bridging, and cause additional settling of particulates. The preferred method of manufacturing the colloidal silica that is substantially free of soluble polymeric silicates is by centrifugation of a slurry concentrate containing between 20% and 35% silica by weight, and diluting the centrifuged silica slurry concentrate when manufacturing the polishing slurry and optionally again at point of use. This process may also provide a narrower particle size distribution in addition to reducing soluble silicates.

Slurries that are substantially free of polymeric silicates have been surprisingly and unexpectedly found to afford low post-CMP defect levels on copper surfaces. In an embodiment, the term "substantially free of soluble polymeric silicates" means that the level of soluble polymeric silicates in the colloidal silica is less than or equal to 0.5% based on the weight of the silica, preferably less than 0.1 %, more preferably less than 0.05%, for example less than or equal to about 0.01 % by weight based on the weight of the silica.

### BRIEF DESCRIPTION OF THE DRAWINGS

The drawings are not essential to understanding and using the invention, as they are graphical presentations of selected polishing data from the Examples.

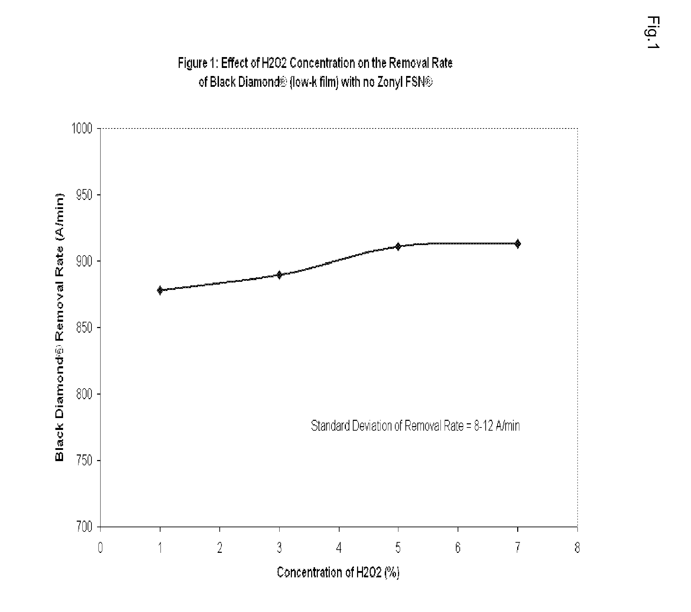

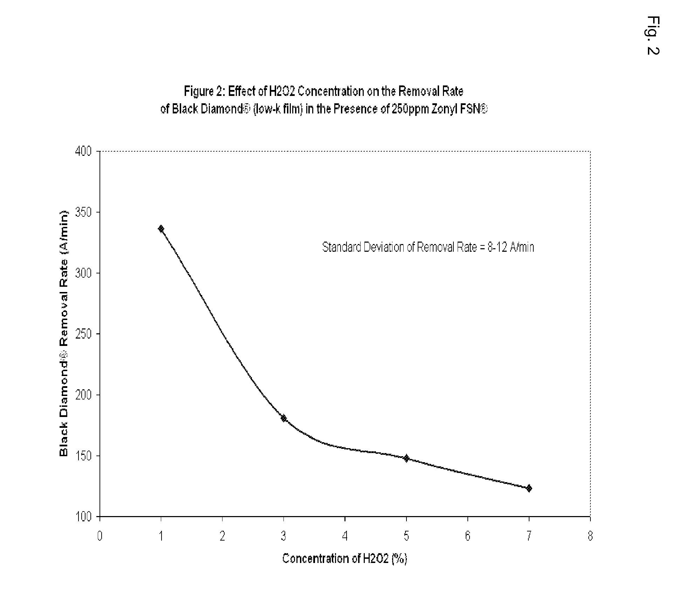

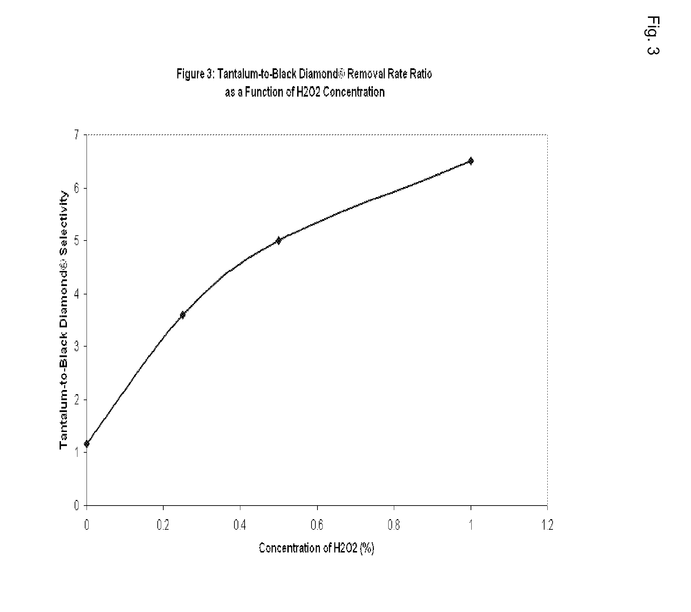

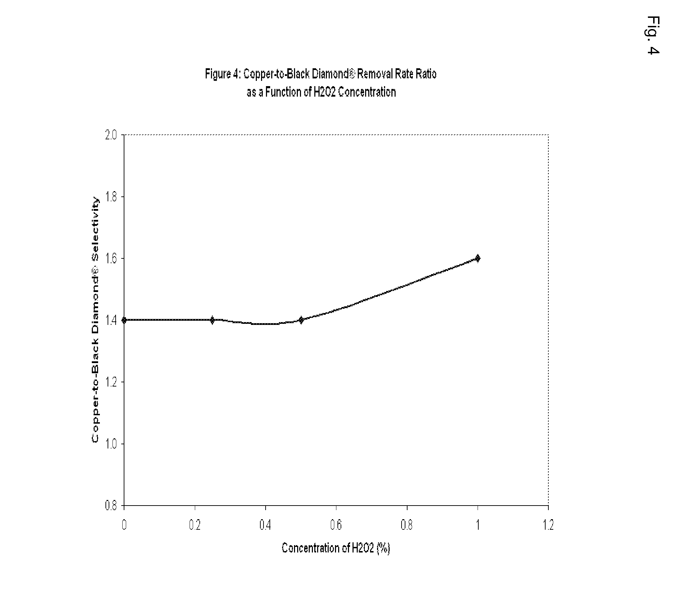

Figure 1 shows the effect of hydrogen peroxide concentration on the removal of low-k film in the absence of non-ionic fluorosurfactant. Figure 2 shows the effect of hydrogen peroxide concentration on the removal of low-k film in the presence of 250 ppm of non-ionic fluorosurfactant. Figure 3 shows the effect of hydrogen peroxide concentration on the selectivity ratio of Ta to low-k film in the presence of non-ionic fluorosurfactant. Figure 4 shows the effect of hydrogen peroxide concentration on the selectivity ration of Cu to low-k film in the presence of non-ionic fluorosurfactant, but at very low hydrogen peroxide concentrations. There appears to be little synergistic effect unless there is at least about 0.5% hydrogen peroxide.

### DETAILED DESCRIPTION OF THE INVENTION

Disclosed herein is a unique synergistic combination of Zonyl FSN® and hydrogen peroxide at different ratios to control the removal rates of Black Diamond® without very little effect on the removal rate of oxide (PETEOS), copper, and barrier layer material. The in-situ reaction product of Zonyl FSN® with H₂O₂ not only provides tunability of Black Diamond® but also reduces defects on the copper surface during polishing. In a preferred embodiment, the invention includes a process for (step 2) polishing a substrate surface comprising copper, a barrier layer, a low-k dielectric material, in particular Black Diamond® or similar carbon-doped oxide such as next generation Black Diamond® or CORAL®, and optionally PETEOS, where the process comprises movably contacting the face of the substrate to be polished with a polishing pad having in the space between the polishing pad and the substrate surface an abrasive and a liquid comprising a per-type oxidizer (preferably hydrogen peroxide) and a non-ionic fluorosurfactant. The amount of non-ionic fluorosurfactant in the polishing composition between 10 ppm and 4000 ppm, typically between 100 ppm and 3000 ppm, for example between 250 ppm and 2000 ppm.

Some manufacturers want to specify various material removal rates, but in general it is often preferable to have the removal rate of each of the barrier layer, the low-k dielectric material, and the PETEOS or other oxide to be within 0.5 times to 2 times the removal rate of copper, preferably within 0.66 times to 1.5 times the removal rate of copper, more preferably within 0.75 times to 1.33 times the removal rate of copper, for example within 0.85 times to 1.2 times the removal rate of copper.

In the absence of the non-ionic fluorinated surfactant, increasing the concentration of H₂O₂ resulted in a slightly increasing Black Diamond® removal rate. On the other hand, in the presence of the non-ionic fluorinated surfactant, increasing the concentration of H₂O₂ resulted in a decreasing Black Diamond® removal rate. This suggests a synergy when H₂O₂ and Zonyl FSN® were used as a mixture. As previously stated, we believe the per-type oxidizer, particularly hydrogen peroxide, reacts with the Zonyl FSN® to create a free radical species, where the free radical species in turn has sufficient energy to bind to the Black Diamond® material and substantially reduce removal rates. The Examples show that a mixture of a fluorinated surfactant (e.g., Zonyl® FSN) and optionally an anionic phosphate fluorosurfactant (e.g., Zonyl® FSP) in the presence of a per-type oxidizer such as 0.25% to 5% H₂O₂, for example 1 % H₂O₂, tunes the removal rates of Black Diamond® at low hydrogen peroxide concentration and low polishing pressure from about 50 Å/min (46 Å/min at 2000ppm Zonyl® FSN) to about 350 Å/min (336 Å/min at 250 PPM of Zonyl FSP). Various additional refinements to the Black Diamond® rates can be obtained by adjusting the pH, the concentration of Zonyl FSN®, and concentration of H₂O₂. Advantageously, the variable removal rates of Black Diamond® are independent of the removal rates of copper, tantalum, and TEOS.

The CMP slurry composition can optionally comprise an anionic phosphate fluorosurfactant (e.g., Zonyl® FSP) in an amount between 10 ppm and 3000 ppm, typically between 100 ppm and 2000 ppm, for example between 250 ppm and 2000 ppm. The anionic phosphate fluorosurfactant can have any of a number of structures. A typical structure (depicted in the acid form) can be represented by the formula R_{f}((R₁O)_{w}R₁O)ₓP(O)(ONH₄)_{y} where: x = 1 or 2, y = 2 or 1, and x+y = 3; R_{f} = X(CX₂)_{z}, where X is F or any combination of H and F provided that at least a portion of the X atoms in the surfactant are F, and where z is from 1 to 18, for example from 2 to 18, in particular from 3 to 14, preferably from 6 to 9, such as about 7; R₁O is independently CH₂CH₂O-, CH₂CH₂CH₂O- , or CₐH₂ₐO- where the number of carbon atoms "a" is between 3 and 8, or any combination of the above, and where w = 0 to 24 or 25, preferably between 0 and 4, more preferably between 1 and 3.

The above structures encompasses (and prefers) block copolymers, that is, a surfactant comprising blocks one or more (R₁O)ₓ segments and/or of R_{f} segments. The invention also encompasses use of slurries where the anionic fluorosurfactant is polydisperse in molecular weight and/or composition.

Preferably at least half, more preferably at least three quarters, of the X atoms in the R_{f} segment are F. Preferably the average y in the R_{f} segment is between 3 and 6.

Preferably, R₁O is independently CH₂CH₂O-, CH₂CH₂CH₂O - , or mixture thereof, more preferably CH₂CH₂O-. A block of CH₂CH₂O- segments will form a hydrophilic section "A", while a block of CH₂CH₂CH₂O - and/or CₐH₂ₐO- segments (where "a" is 3 or more) will form a hydrophobic section "B." For use on second generation low-k materials having a dielectric constant below 2.4, blocks of polyoxypropylene advantageously can be included with the blocks of hydrophilic polyoxyethylene to increase the hydrophobicity of the non-ionic fluorosurfactant. A particularly preferred anionic phosphate fluorosurfactant is Zonyl FSP®, obtained from E.I. DuPont de Nemours, Wilmington, DE, which is believed to have the following formula:

R_{f}(CH₂CH₂O)ₓP(O)(ONH4)_{y}

Where R_{f} = F(CF₂CF₂)_{z}
x = 1 or 2
y = 2 or 1
x+y=3
z=1to7

Other chemicals that may be added to the CMP slurry composition include, for example, other non-ionic surfactants, pH-adjusting agents, corrosion inhibitors, fluorine-containing compounds, chelating agents, nitrogen-containing compounds, and salts. Some of these compounds can tune the removal rate of one or more of the copper, the barrier layer material (usually Ta, TaN, Ti, TiN, or some combination thereof), the low-k dielectric material, and the PETEOS.

The CMP slurry composition can additionally comprise pH adjusting compounds. Typically slurries used for copper (including slurries of this invention) are basic, and have a pH greater than 7.5, more often greater than 8. Any pH adjusting compounds normally used in the art can be used, though potassium hydroxide is preferred. As benzenesulfonic acid is present in preferred slurries of this invention, potassium hydroxide is advantageously included in an amount between 0.05% to 1%, for example between 0.2% to 0.8% by weight. Advantageously the pH of the slurry composition prior to adding hydrogen peroxide is greater than 8, for example between 9 and 12, preferably between 10 and 11.5, for example between 10.4 and 11.1.

The CMP slurry composition can additionally comprise other non-ionic surfactants such as Tectronics 90R. This surfactant also has some activity in tuning (reducing) the removal rates of Black Diamond^{™} low-k material, but this material is not as effective as the non-ionic fluorosurfactant at tuning the Black Diamond^{™} removal rates without effecting the copper and other non-ionic surfactants do not reduce polishing defects as much as the preferred non-ionic fluorosurfactant. If present, such other non-ionic surfactants are present in the range between 50 to 1000 ppm.

The CMP slurry composition can additionally comprise film-forming agents/corrosion inhibitors adapted to reduce the Cu removal rate and/or reduce Cu static etching. Preferably the CMP slurry composition contains at least one such corrosion inhibitor. Suitable corrosion inhibitors that may be added to the slurry composition include, for example, amino acid derivatives, 6-tolylytriazole, tolyltriazole derivatives, 1-(2,3-dicarboxypropyl)benzotriazole, N-acyl-N-hydrocarbonoxyalkyl aspartic acid compounds, and mixtures thereof. The corrosion inhibitor may be present in the slurry in a concentration of 10 ppm to 4000 ppm, preferably 10 ppm to 900 ppm, and more preferably from 50 ppm to 400 ppm of the total weight of the slurry. Useful corrosion inhibitors are CDX2128 and CDX2165, both supplied by King Industries, Inc., Norwalk, Conn. Preferred corrosion inhibitors include benzotriazole and tolyltriazole derivatives, most preferably benzotriazole. Advantageously the amount of this film-forming agent is between 50 ppm and 200 ppm.

The CMP slurry composition can optionally comprise a polyvinylpyridine-N-oxide polymer (PVNO). If present, advantageously the PVNO polymer has a number average molecular weight ranging from 25,000 Daltons to 250,000 Daltons, and is present in an amount between 0.01% to 0.75%, for example between 0.05% and 0.4% by weight. PVNO can tune TEOS rates relative to copper and to barrier materials. However, PVNO is relatively ineffectual with respect to low-k materials such as Black Diamond®.

The CMP slurry composition can optionally comprise a polyalkyleneimine. If present, advantageously the polyalkyleneimine is present in an amount between 0.01% to 0.75%, for example between 0.05% and 0.4% by weight.

The CMP slurry composition can optionally comprise chelating agents. Suitable chelating agents that may be added to the slurry composition include, for example, ethylenediaminetetracetic acid (EDTA), N-hydroxyethylethylenediaminetriacetic acid (NHEDTA), nitrilotriacetic acid (NTA), diethylenetriaminepentacetic acid (DPTA), ethanoldiglycinate, tricine (which is also a pH-adjusting agent) and mixtures thereof. The chelating agents may be present in the slurry composition in a concentration of 0% to 3%, typically from 0.02% to 2%, for example from 0.05% to 0.5% of the total weight of the slurry. Tricine is a useful chelating agent/pH-adjusting agent.

The slurry compositions of this invention are used in the chemical-mechanical planarization of substrates such as integrated circuits and semiconductors. The polishing method generally includes the steps of: A) placing a substrate surface comprising copper metal, a low-k dielectric material, and a barrier material in contact with a polishing pad; B) delivering the slurry compositions to the space between the polishing pad and the substrate surface; and C) planarizing the substrate.

### DESCRIPTION OF THE PREFERRED EMBODIMENTS

Reference will now be made in detail to the preferred embodiments of the present invention, examples of which are illustrated. The preferred barrier layer slurry of this invention comprises: water; between 2% and 7%, preferably between 3.5% and 6%, of silicate-free colloidal silica abrasive; between 0.25% and 9% of a per-type oxidizer, preferably between 0.5% and 5% of a per-type oxidizer hydrogen peroxide; between 0.5% and 2% of benzenesulfonic acid; between 50 ppm and 400 ppm of a corrosion inhibitor, for example benzotriazole; between 0.2% and 1%, typically 0.4% to 0.7% of a base, preferably potassium hydroxide, sufficient to attain a pH of between 10.2 and 11.4; between 0 and 3000 ppm, preferably between 100 ppm and 1000 ppm of a non-ionic fluorosurfactant; and between 0 and 3000 ppm, preferably between 100 ppm and 1000 ppm of an anionic phosphate fluorosurfactant.

Unless otherwise specified, substrate removal rates are in angstroms per minute ("Å/min", equal to 0.1 nm/min), and all percentages and parts per million ("ppm") are by weight.

The following examples further illustrate details for the method and compositions of this invention. The invention is not to be limited in scope by these examples. Those skilled in the art will readily understand that known variations of the conditions of the following procedures can be used.

### EXAMPLES

Information regarding processes, terminology, and sources of materials used in the various examples is provided below.
-- Colloidal silica is Syton^{®} OX-K obtained from DuPont Air Products NanoMaterials L.L.C., Tempe, AZ, and having - 55-80 nm particles.
-- Centrifuged potassium stabilized colloidal silica is DP290™, obtained from DuPont Air Products NanoMaterials L.L.C.,Tempe, AZ, and having -60-75 nm particles.
-- Benzene sulfonic acid was obtained from DynaChem Inc., P.O.Box; 19, Maple Grove road, Georgetown, IL 61846.
-- Plurafac® S505LF was obtained from BASF Corporation, 3000 Continental Drive, North Mount Olive,N.J.07828.
-- Zonyl FSP®, obtained from E.I. DuPont de Nemours, Wilmington, DE, is an anionic phosphate fluorosurfactant believed to have the following formula:

   Rf(CH₂CH₂O)ₓP(O)(ONH4)

   Where Rf = F(CF₂CF₂)_{z}
   x = 1 or 2
   y = 2 or 1
   x+y=3
   z =1 to 7
-- Zonyl® FSN®, obtained from E.l. DuPont de Nemours, Wilmington, DE, is a non-ionic fluorinated surfactant, and a mixture of telomeric monoether with polyethylene glycol. The structure is as follows:

   R_{f}CH₂CH₂O(CH₂CH₂O)ₓH:

   Where R_{f} = F (CF2CF2)_{y}
   x = 0 to 25
   y= 1 to 9
-- Polishing Pads used in examples were Politex®, and IC1000 obtained from Rodel, Inc, Phoenix, AZ.
-- TEOS is Tetraethyl Orthosilicate, Si(OC₂H₅)₄, a compound commonly used in chemical vapor deposition of SiO₂ (so-called "TEOS Oxide").
-- PETEOS is the dielectric silicon oxide layer formed by plasma enhanced deposition of tetraethoxy silane.

Symbols and definitions are provided below:
A is angstrom(s), a unit of length (= 0.1 nm);
Å/min is a polishing rate in angstroms per minute;
BP is back pressure, in units of psi;
CMP is chemical mechanical planarization = chemical mechanical polishing;
CS is the carrier speed;
DF is the down force, or pressure, applied during CMP, in units of psi;
min is minute(s);
ml is milliliter(s);
mV is millivolt(s);
psi is pounds per square inch (1 psi = 6.9 kPa);
PS is the platen rotational speed of polishing tool, in rpm (revolution(s) per minute); and
SF is the slurry flow in ml/min.

All percentages are weight percentages unless otherwise indicated, and small concentrations are typically depicted as parts per million by weight ("ppm").

In blanket wafers studies, groupings were made to simulate successive film removal: first copper, next tantalum, and finally the PETEOS. The tool mid-point conditions were: table speed; 123 rpm, head speed; 112 rpm, membrane pressure, 2.0 psi (13.8 kPa); inter-tube pressure, 0.0 psi (0.0 kPa); and 200 ml/min SF. Polishing experiments were conducted using electrochemically deposited copper, tantalum, Black Diamond®, and PETEOS blanket wafers. The PETEOS blanket wafers had 15,000 Å on silicon, the Copper blanket wafers had 10,000 Å electroplated copper/1,000 Å copper seed/250 Å Ta on silicon; and the Tantalum blanket wafers had 2000 Å Ta/5,000 Å thermal oxide on silicon. These wafers were purchased from Silicon Valley Microelectronics, 1150 Campbell Ave, CA, 95126.

Black Diamond® is a low-k dielectric film from Applied Materials, 3050 Boweres Avenue, Santa Clara, California, 95054. This film is an organosilicate glass (OSG) with alkylated silicon atom. This invention also applies to other organosilicate glass films such as Coral® from Novellus, 4000, North First Street, San Hose, California, 95134. Both low-k films Black Diamond and Coral are alkylated during the CVD (Chemical vapor deposition) process.

Polishing parameters and data acquisition and presentation used in the examples, unless otherwise specified, were:
"Cu RR 2 psi" is the measured copper removal rate in Å/min at a DF of 2 psi (13.8 kPa);
"Ta RR 2 psi" is the measured tantalum removal rate in Å/min at a DF of 2 psi (13.8 kPa);
"PETEOS RR 2 psi" is the measured PETEOS removal rate in Å/min at a DF of 2 psi (13.8 kPa);
"TEOS RR 2 psi" is the measured TEOS removal rate in Å/min at a DF of 2 psi (13.8 kPa); and
"Black Diamond® RR 2 psi" is the measured Black Diamond® removal rate in Å/min at a DF of 2 psi (13.8 kPa).

PETEOS thickness and Black Diamond® thickness was measured with an oxide thickness measuring instrument, Nanometrics, model, #9200, manufactured by Nanometrics Inc, 1550 Buckeye, Milpitas, CA 95035-7418. The metal films were measured with a metal thickness measuring instrument, ResMap CDE, model 168, manufactured by Creative Design Engineering, Inc, 20565 Alves Dr, Cupertino, CA, 95014. The ResMap tool is a four-point probe sheet resistance tool. Twenty-five and forty nine-point polar scans were taken with the respective tools at 3-mm edge exclusion.

The CMP tool that was used is a Mirra^{®}, manufactured by Applied Materials, 3050 Boweres Avenue, Santa Clara, California, 95054. A Rodel Politex® embossed pad, supplied by Rodel, Inc, 3804 East Watkins Street, Phoenix, AZ, 85034, was used on the platen for the blanket wafer polishing studies. Pads were broken-in by polishing twenty-five dummy oxide (deposited by plasma enhanced CVD from a TEOS precursor, PETEOS) wafers. In order to qualify the tool settings and the pad break-in, two PETEOS monitors were polished with Syton^{®} OX-K colloidal silica, supplied by DuPont Air Products NanoMaterials L.L.C., at baseline conditions.

### EXAMPLES

Example 1-8 shows the effect of a non-ionic fluorinated surfactant (Zonyl FSN), and H₂O₂ concentration on the removal rates of Black Diamond® and Tuneability ratios of Cu/Black Diamond® and Ta/Black Diamond®.

All of the slurries used in this first set of Examples were prepared following a similar 6-step procedure. The comparative CMP slurry in Example 1 was prepared as follows. Step 1: In a 5-liter beaker, 100 grams of 30% benzenesulfonic acid ("BSA") were added to 2139.50 grams of deionized water and allowed to stir using a magnetic stirrer for 2 minutes. Step 2: Under agitation, 600 grams of a 25 wt % aqueous slurry of polysilicate-free deionized colloidal silica were added slowly during a period of 2 minutes. Step 3: After allowing the mixture to stir for 5 minutes, 123 grams of a 10% wt aqueous solution of potassium hydroxide were added slowly. Step 4: Nothing was added in Step 4 of the comparative example. Step 5: After stirring for an additional 2 minutes, 30 grams of a 1 wt % aqueous solution of benzotriazole ("BTA") were added. Step 6: Directly before polishing, 300 grams of a 30 wt % aqueous solution of hydrogen peroxide were added to the sample. The slurry composition of example 1, based on the added components, is summarized below:

| Comparative Example 1, Components | ~ 3 Kg of slurry | Weight percent |
|---|---|---|
| Deionized water | 2710 grams | 90.54 |
| Benzenesulfonic acid | 30 grams | 1.00 |
| Polysilicate-free deionized colloidal silica, DP290 | 150 grams | 5.01 |
| Potassium hydroxide | 12.3 grams | 0.41 |
| Benzotriazole | 0.3 grams | 0.01 |
| Hydrogen peroxide | 90 grams | 3.01 |

The CMP slurry in Example 2 was prepared by following steps 1, 2, and 3 as described for Example 1. In step 4, however, after 2 minutes of stirring, 7.50 grams of a 10 wt % aqueous solution of Zonyl FSN ® were added and allowed to stir for an additional 2 minutes. Then, steps 5 and 6 as described for Example 1 were completed. The components of example 2 are summarized below:

| Example 2, Components | ~ 3 Kg of slurry | Weight percent |
|---|---|---|
| Deionized water | 2717 grams | 90.57 |
| Benzenesulfonic acid | 30 grams | 1.00 |
| Polysilicate-free deionized colloidal silica, DP290 | 150 grams | 5.00 |
| Potassium hydroxide | 12.3 grams | 0.41 |
| Zonyl FSN | 0.75 grams | 0.025 |
| Benzotriazole | 0.3 grams | 0.01 |
| Hydrogen peroxide | 90 grams | 3.00 |

Polishing slurries were prepared for Examples 3-8 following the procedure described in comparative Example 1 or Example 2. The compositions of these slurries, given as weight percent of materials added to the slurries, are presented in Table 1. The slurry of comparative Example 3 has the same composition as comparative Example 1, that is, with no Zonyl FSN®, except comparative example 3 has 3% H₂O₂ instead of 1.0% H₂O₂ as shown in example 1. The slurry of Example 4 has the same composition as Example 2, including the 250 ppm Zonyl FSN®, except Example 4 has 3% H₂O₂ instead of 1.0% H₂O₂ shown in Example 2. The slurry of comparative Example 5 has the same composition as comparative Example 1, that is, with no Zonyl FSN®, except comparative Example 5 has 5% H₂O₂ instead of 1.0% H₂O₂ shown in Example 1. The slurry of Example 6 has the same composition as Example 2, including the 250 ppm Zonyl FSN®, except Example 6 has 5% H₂O₂ instead of 1.0% H₂O₂ shown in Example 2. The slurry of comparative Example 7 has the same composition as comparative Example 1, that is, with no Zonyl FSN®, except comparative example 7 has 7% H₂O₂ instead of 1.0% H₂O₂ as shown in comparative Example 1. The slurry of Example 8 has the same composition as Example 2, including the 250 ppm Zonyl FSN®, except Example 8 has 7% H₂O₂ instead of 1.0% H₂O₂ shown in Example 2. This set of experiments allows examination of the effects of a small amount of non-ionic fluorinated surfactant and of hydrogen peroxide concentration on the tunability of Black Diamond and similar low-k materials.

| Table 1 | Comp Ex.1 | Ex.2 | Comp Ex.3 | Ex.4 | Comp Ex.5 | Ex.6 | Comp Ex.8 | Ex.8 |
|---|---|---|---|---|---|---|---|---|
| Silica, wt % | 5 | 5 | 5 | 5 | 5 | 5 | 5 | 5 |
| BSA, wt % | 1.0 | 1.0 | 1.0 | 1.0 | 1.0 | 1.0 | 1.0 | 1.0 |
| KOH, wt % | 0.59 | 0.59 | 0.59 | 0.59 | 0.59 | 0.59 | 0.59 | 0.59 |
| BTA, ppm | 100 | 100 | 100 | 100 | 100 | 100 | 100 | 100 |
| Zonyl FSN®, ppm | 0 | 250 | 0 | 250 | 0 | 250 | 0 | 250 |
| H₂O₂, wt % | 1.0 | 1.0 | 3.0 | 3.0 | 5.0 | 5.0 | 7.0 | 7.0 |
| pH before H₂O₂ | 11.1 | 11.1 | 11.1 | 11.1 | 11.1 | 11.1 | 11.1 | 11.1 |
| Cu RR 2 psi, Å/min | 160 | 154 | 158 | 146 | 154 | 155 | 157 | 182 |
| Ta RR 2 psi, Å/min | 400 | 384 | 451 | 455 | 466 | 491 | 475 | 497 |
| Black Diamond® RR 2 psi Å/min | 878 | 336 | 890 | 181 | 911 | 148 | 913 | 123 |
| PETEOS RR 2 psi Å/min | 326 | 367 | 383 | 329 | 273 | 295 | 254 | 283 |
| Selectivity, Ta/ Black Diamond® | 0.45 | 1.1 | 0.5 | 2.5 | 0.51 | 3.3 | 0.52 | 4.0 |
| Selectivity, Cu / Black Diamond® | 0.18 | 0.45 | 0.17 | 0.8 | 0.16 | 1.0 | 0.17 | 1.4 |
| Selectivity, PETEOS/ Black Diamond® | 0.37 | 1.09 | 0.43 | 1.82 | 0.30 | 1.99 | 0.28 | 2.3 |
| Selectivity, Ta / PETEOS | 1.23 | 1.05 | 1.18 | 1.38 | 1.71 | 1.66 | 1.87 | 1.76 |
| Selectivity, Cu/ PETEOS | 0.49 | 0.42 | 0.41 | 0.44 | 0.56 | 0.53 | 0.62 | 0.64 |

In table, 1, the effect of a non-ionic fluorinated surfactant, Zonyl FSN, and of a per-type oxidizer, H₂O₂, on the removal rates of Black Diamond ® and tuneability ratios of Cu/Black Diamond® and Ta/Black Diamond® is shown.

The polishing data show that the non-ionic fluorinated surfactant Zonyl FSN® at 250 ppm and H₂O₂ concentration between 1% and 7% has very little impact on the removal rate of copper. The copper removal rate range stayed between 146 Å/min to 182 Å/min with or without any non-ionic fluorinated surfactant over the entire H₂O₂ concentration tested.

The polishing data also show that the non-ionic fluorinated surfactant Zonyl FSN® at 250 ppm and H₂O₂ concentration between 1% and 7% has only a small impact on the removal rate of oxide (PETEOS). The oxide removal rate stayed between 254 Å/min to 383 Å/min. This is substantially constant, as the scatter in the oxide RR measurements is typical in this type of experiment. At low hydrogen peroxide levels of 1%, the presence of the non-ionic fluorinated surfactant may increase the PETEOS removal rate by a small amount of about 30 Å/min, while at higher peroxide concentrations near 7% the presence of the non-ionic fluorinated surfactant may decrease the PETEOS removal rate by a small amount of about 30 Å/min. Generally, in the industry such variation is negligible.

The polishing data also show that the non-ionic fluorinated surfactant, e.g., Zonyl FSN®, at 250 ppm has only a small impact on the removal rate of barrier material such as Ta. It can be seen that as the concentration of H₂O₂ increased from 1% and 7%, a slurry having no non-ionic fluorinated surfactant gave Ta removal rates increasing from 400 Å/min (at 1% H₂O₂) to 475 Å/min (at 7% H₂O₂). Ta removal rates are therefore tunable (within a very narrow range of about 12 Å/min/% H₂O₂) relative to copper and oxide simply by varying the concentration of H₂O₂. The presence of the non-ionic fluorinated surfactant gave Ta removal rates increasing from 384 Å/min (at 1 % H₂O₂) to 497 Å/min (at 7% H₂O₂). The non-ionic fluorinated surfactant at 250 ppm therefore had very little impact on the Ta removal rates, although the effect of the varying hydrogen peroxide on the Ta removal rate was slightly higher (about 20 Å/min/% H₂O₂).

In the absence of the non-ionic fluorinated surfactant, increasing the concentration of H₂O₂ from 1.0 wt % to 7.0 wt % resulted in a gradual monotonic increase in the removal rate of Black Diamond@ from 878 Å/min to 913 Å/min. As shown in Example 2, addition of 250 ppm of Zonyl FSN® to a slurry containing 1 % H₂O₂ decreased the removal rate of Black Diamond® from 878 Å/min to 336 Å/min. Surprisingly, as the concentration of H₂O₂ increased from 1.0 wt % to 3.0 wt % in the presence of the 250 ppm of Zonyl FSN®, the Black Diamond@ removal rate decreased from 336 Å/min to 181 Å/min. In the absence of the non-ionic fluorinated surfactant, increasing the concentration of H₂O₂ resulted in a slightly increasing Black Diamond@ removal rate. On the other hand, in the presence of the non-ionic fluorinated surfactant, increasing the concentration of H₂O₂ resulted in a decreasing Black Diamond@ removal rate. This suggests a synergy when H₂O₂ and Zonyl FSN® were used as a mixture. As previously stated, we believe the per-type oxidizer, particularly hydrogen peroxide, reacts with the Zonyl FSN® to create a free radical species, where the free radical species in turn has sufficient energy to bind to the Black Diamond® material and substantially reduce removal rates. The data is also plotted in Figures 1,2, and 3

Hence, this novel approach provides tunability of Cu /Black Diamond® and Ta/Black Diamond®.

In examples 9-14, the effect of somewhat higher concentrations of a non-ionic fluorinated surfactant, Zonyl FSN®, at low concentrations of H₂O₂ and lower concentration of potassium hydroxide was studied. Compared to examples 1-8, the amount of potassium hydroxide was reduced from 0.59 wt % to 0.41 %. Example 9-14 compositions are shown in Table 2, and are summarized below:
Example 9; no Zonyl FSN®, 1.0 % H₂O₂;
Example 10; 500 ppm Zonyl FSN®, no H₂O₂;
Example 11; 500 ppm Zonyl FSN®, 0.25 % H₂O₂;
Example 12; 500 ppm Zonyl FSN®, 0.5 % H₂O₂;
Example 13; 500 ppm Zonyl FSN®, 1 % H₂O₂;
Example 14; 2000 ppm Zonyl FSN®, 1.0 % H₂O₂;

Table 2: Effect of Zonyl FSN, and H2O2 at different concentrations of Zonyl FSN®, and H2O2 on the Removal rates of Black Diamond ® and Tuneability ration of Cu/Black Diamond® and Ta/Black Diamond® is shown in the polishing data of these examples.

| Table 2 | Comp. Ex. 9 | Comp. Ex.10 | Comp. Ex.11 | Ex. 12 | Ex. 13 | Ex. 14 |
|---|---|---|---|---|---|---|
| Silica (polysilicate free), wt % | 5 | 5 | 5 | 5 | 5 | 5 |
| Benzesulfonic acid (BSA), wt % | 1.0 | 1.0 | 1.0 | 1.0 | 1.0 | 1.0 |
| Potassium hydroxide, wt % | 0.41 | 0.41 | 0.41 | 0.41 | 0.41 | 0.41 |
| Benzotriazole (BTA), ppm | 100 | 100 | 100 | 100 | 100 | 100 |
| Zonyl FSN®, ppm | 0 | 500 | 500 | 500 | 500 | 2000 |
| H₂O₂, wt% | 1.0 | 0 | 0.25 | 0.5 | 1.0 | 1.0 |
| pH before H₂O₂ | 10.3 | 10.3 | 10.3 | 10.3 | 10.3 | 10.3 |
| Cu RR 2 psi, Å/min | 154 | 187 | 140 | 129 | 121 | 72 |
| Ta RR 2 psi, Å/min | 438 | 156 | 366 | 417 | 469 | 382 |
| Black Diamond® RR 2 psi, Å/min | 742 | 133 | 99 | 82 | 72 | 46 |
| PETEOS RR 2 psi, Å/min | 310 | 336 | 310 | 310 | 307 | 236 |
| Selectivity of Ta/ Black Diamond® | 0.5 | 1.17 | 3.6 | 5.0 | 6.5 | 8.3 |
| Selectivity of Cu /Black Diamond® | 0.2 | 1.4 | 1.4 | 1.4 | 1.6 | 1.5 |

In Table, 2, effect of different concentrations of Zonyl FSN®, and different concentrations of H₂O₂ on the removal rates of Black Diamond® and tunability ratio of Cu/Black Diamond® and Ta/Black Diamond® is summarized. In examples 10-13, the amount of Zonyl FSN® was fixed at 500-PPM, and the amount of H₂O₂ concentration was varied from zero to 1 wt %. As the concentration of H₂O₂ increased, the Black Diamond® rate decreased from 133 Å/min to 72 Å/min with very little change in the removal rate of copper, and TEOS, thus providing excellent tunability with respect to copper, TEOS, and tantalum.

Also, a comparison of example 9 and 10 shows that without H₂O₂ at 500 ppm of Zonyl FSN®, Black Diamond® removal rate drops dramatically and it became difficult to fine-tune Black diamond® removal rates with respect to copper, and TEOS. Hence, use of mixtures of Zonyl FSN®, and H₂O₂ offer great potential to tune Black Diamond® removal rates.

Example 9 is the control - with no treatment, the removal rate of Black Diamond® is unacceptably large. As shown in comparative example 10, in the absence of hydrogen peroxide, and with 500 ppm Zonyl FSN®, the removal rate of Black Diamond® is 133 Å/min. Adding just 0.25% hydrogen peroxide with 500 ppm Zonyl FSN® reduced the removal rate of Black Diamond® to 99 Å/min. Further increases in the hydrogen peroxide concentration to 1% with 500 ppm Zonyl FSN® resulted in further decreases in the removal rate of Black Diamond® to 72 Å/min. This is surprising, as in the absence of the non-ionic fluorinated surfactant increases in the hydrogen peroxide concentration increase the removal rate of Black Diamond®.

It is noted that with 1% hydrogen peroxide slurries, 250 ppm of Zonyl FSN® reduced the removal rate of Black Diamond® to 336 Å/min, while 500 ppm of Zonyl FSN® reduced the removal rate of Black Diamond® to 133 Å/min. The degree of reduction in the removal rate of Black Diamond® is very sensitive to the concentration of the non-ionic fluorinated surfactant. This provides a very powerful tool, allowing a very great range in the tenability of the removal rate of low-k materials relative to each of the removal rates of Cu, Ta, and oxide.

Indeed, it is possible to substantially shut down the removal rate of Black Diamond®. Adding to a 1% hydrogen peroxide slurry 2000 ppm of Zonyl FSN® reduced the removal rate of Black Diamond® to a negligible 46 Å/min. However at high concentration of Zonyl FSN®, there is a dramatic decrease in the PETEOS removal rate.

In examples 15-32, the amount of potassium hydroxide was 0.41 wt % instead of 0.59% as in Examples 1-8. These examples examined the effects of variations in the type of surfactants containing in various formulations. The mixing and polishing procedures were as described for previous examples. As an illustration the procedure for Example 16 that contains 500 ppm of Zonyl FSP® is described below.

Example 16 uses 500 ppm of Zonyl FSP®. This is an anionic phosphate fluorosurfactant, as opposed to the non-ionic fluorinated surfactant used in previous examples. In a 5-liter beaker, 100 grams of benzenesulfonic acid were added to 2139.50 grams of deionized water and allowed to stir using a magnetic stirrer for 2 minutes. Under agitation, 600 grams of polysilicate-free de-ionized colloidal silica were added slowly during a period of 2 minutes. After allowing the mixture to stir for 5 minutes, 85.47 grams of potassium hydroxide were added slowly. After 2 minutes of stirring, 15 grams of Zonyl FSP® were added and allowed to stir for an additional 2 minutes. After stirring for an additional 2 minutes, 30 grams of benzotriazole were added. Directly before polishing, 300 grams of hydrogen peroxide were added to the sample.

The components of Example 16 are summarized below:
1) Deionized water = 1839.50 grams
2) Benzenesulfonic acid (30 wt % aqueous solution) = 100 grams
3) Polysilicate-free deionized colloidal silica, (25 wt % aqueous slurry) = 600 grams
4) Potassium hydroxide (10 wt % aqueous solution) = 85.47grams
5) Zonyl FSP® (10 wt % aqueous solution) = 15.0 grams
6) Benzotriazole (1 wt % aqueous solution) = 30 grams
7) Hydrogen peroxide (30 wt % aqueous solution) = 300 grams

In all tables, unless otherwise specified, the amount of active surfactant is provided in ppm by weight, as opposed to the amount of the commercial product (e.g., Zonyl FSP®) added.

The compositions of control Examples 15, and examples 16-29 containing Zonyl FSP®, Zonyl FSN®, and mixtures of Zonyl FSP® and Zonyl FSN®, and other surfactants are summarized below:
Example 15; No Zonyl FSN®, no Zonyl FSP®, added 1% H₂O₂.
Example 16; 500 ppm Zonyl FSP®, added 1% H₂O₂.
Example 17; 500 ppm Zonyl FSN®, added 3% H₂O₂.
Example 18; 500 ppm Zonyl FSP®, added 1% H₂O₂.
Example 19; 2000 ppm Zonyl FSP®, added 1.4% H₂O₂.
Example 20; no Zonyl FSN®, No Zonyl FSP®, added 1% H₂O₂.
Example 21; 1000 ppm Zonyl FSN®, no Zonyl FSP®, added 1% H₂O₂.
Example 22; 1000 ppm Zonyl FSN®, 500 PPM Zonyl FSP®, added 1 % H₂O₂.
Example 23; 1000 ppm Zonyl FSN®, and 1000 PPM zonyl FSP®, added 1% H₂O₂.
Example 24; 2000 ppm Zonyl FSP®, and 1000 PPM Zonyl FSN®, added 1% H₂O₂.
Example 25; 500 ppm Zonyl FSP®, added 1 % H₂O₂.
Example 26; 2000 ppm Zonyl FSP®, added 1% H₂O₂.
Example 27; 500 ppm Zonyl FSN®, added 1% H₂O₂.
Example 28; 500 ppm Zonyl FSN®, added 3% H₂O₂.
Example 29; 500 ppm Zonyl FSN®, added 5% H₂O₂.
Example 30; 500 ppm Plurafac S505LF®, added 1 % H₂O₂.
Example 31; 500 ppm Plurafac S505LF®, added 3% H₂O₂.
Example 32; 500 ppm Plurafac S505LF®, added 5% H₂O₂.

In Table 3 below, Examples 15-17, a comparison of Zonyl FSN® and Zonyl FSP® on the removal rates of Black Diamond® and tuneability ratio of Cu/Black Diamond® and Ta/Black Diamond® is summarized. In examples 16 and 17, the amount of Zonyl FSN® (in Ex 16) and Zonyl FSP® (in Ex 17) was 500 ppm. Surprisingly, Zonyl FSP® had very little effect on the Black Diamond® removal rate. The control with no surfactant had a Black Diamond® removal rate of 592 Å/min, the slurry with 500 ppm Zonyl FSP had a Black Diamond® removal rate of 325 Å/min, while the slurry with 500 ppm Zonyl FSN had a Black Diamond® removal rate of only 33 Å/min (though at a higher hydrogen peroxide concentration). We believe a phosphate moiety allows the surfactant to resist becoming a free radical, or alternatively the phosphate moiety donates/accepts electrons so fast that most free radical formed in the slurry will self-quench.

Comparison of Various Zonyl Fluorosurfactants on the Removal Rates of Black Diamond® and Tuneability ratios of Cu/Black Diamond® and Ta/Black Diamond® is examined in the Examples shown in Table 3.

| Table 3: | Comp. Ex. 15 | Ex. 16 | Ex. 17 |
|---|---|---|---|
| Silica (polysilicate free), wt % | 5 | 5 | 5 |
| Zonyl FSP® Surfactant, ppm | none | 500 | none |
| Zonyl FSN® Surfactant, ppm | none | none | 500 |
| Benzesulfonic acid, wt % | 1.0 | 1.0 | 1.0 |
| Potassium hydroxide, wt % | 0.41 | 0.41 | 0.41 |
| Benzotriazole, ppm | 100 | 100 | 100 |
| H₂O₂, wt% | 1.0 | 1.0 | 3.0 |
| pH before H₂O₂ | 10.4 | 10.4 | 10.4 |
| Cu RR 2 psi, Å/min | 77 | 88 | 57 |
| Ta RR 2 psi, Å/min | 482 | 325 | 329 |
| Black Diamond® RR 2 psi, Å/min | 592 | 398 | 33 |
| PETEOS RR 2 psi RR, Å/min | 291 | 144 | 180 |
| Selectivity, Ta/ Black Diamond® | 0.81 | 0.81 | 9.9 |
| Selectivity, Cu/ Black Diamond® | 0.13 | 0.22 | 1.7 |

Using an anionic phosphate fluorosurfactant such as Zonyl FSP allows further tunability of the slurry. The anionic phosphate fluorosurfactant reduces the Ta removal rate by almost a third, from 482 Å/min to 325 Å/min in a slurry having 1% hydrogen peroxide. In this series of experiments, the nonionic fluorosurfactant also reduced Ta removal rates, though the effect was minor compared to the almost 95% reduction in the Black Diamond® removal rate. The anionic phosphate fluorosurfactant such as Zonyl FSP also reduced oxide rates significantly, from 291 Å/min to 144 Å/min in a slurry having 1% hydrogen peroxide. The nonionic fluorosurfactant reduced the oxide rate, but to a lesser extent than did the anionic phosphate fluorosurfactant.

In Table 4 below, Examples 18-20, a series of experiments show the effect of Zonyl FSP® concentration on the removal rates of Black Diamond@ and tuneability ratio of Cu/Black Diamond@ and Ta/Black Diamond@. As the concentration of Zonyl FSP® increased from 500 ppm to 2000 ppm, the removal rate of Black Diamond@ was essentially unchanged, decreasing only from 415 Å/min to 392 Å/min. Example 14, having 2000 ppm of the nonionic fluorosurfactant Zonyl FSN® (data in table 2) under similar conditions decreased the removal rate of Black Diamond® from 742 Å/min to 46 Å/min. Clearly, in a slurry containing peroxide, to reduce the polishing rate of Black Diamond and similar low-k surfaces the surfactant can not contain a highly polar phosphate moiety or similar moiety, e.g., sulfate, sulfonate, or the like, which would stabilize the surfactant against forming the free radical species which weakly (but possibly covalently) binds to and protects the low-k material surface.

Table 4 shows the effect of Zonyl FSP Concentration on the removal rates of Black Diamond® and Tuneability ratios of Cu/Black Diamond® and Ta/Black Diamond®.

| Table 4 | Example 18 | Example 19 | Comp. Ex. 20 |
|---|---|---|---|
| Zonyl FSP® Surfactant, ppm | 500 ppm | 2000 ppm | none |
| Silica (polysilicate free), wt % | 5 | 5 | 5 |
| Benzesulfonic acid, wt % | 1.0 | 1.0 | 1.0 |
| Potassium hydroxide, wt % | 0.41 | 0.41 | 0.41 |
| Benzotriazole, ppm | 100 | 100 | 100 |
| H₂O₂, wt% | 1.0 | 1.4 | 1.4 |
| pH before H₂O₂ | 10.4 | 10.4 | 10.4 |
| Cu RR 2 psi, Å/min | 92 | 68 | 77 |
| Ta RR 2 psi, Å/min | 473 | 466 | 482 |
| Black Diamond® RR 2 psi, Å/min | 415 | 392 | 592 |
| PETEOS RR 2 psi RR, Å/min | 297 | 297 | 291 |
| Selectivity, Ta/ Black Diamond® | 1.13 | 1.18 | 0.8 |
| Selectivity, Cu /Black Diamond ® | 0.22 | 0.17 | 0.13 |

In Table 5 below, Examples 21-26, the effect of different concentrations of mixtures of Zonyl FSP® and Zonyl FSN® on the removal rates of Black Diamond ® and tuneability ratio of Cu/Black Diamond® and Ta/Black Diamond® is summarized. In each of Examples 21-26, to reduce the number of variables, the hydrogen peroxide was held at 1%, potassium hydroxide at 0.41%, BTA at 100 ppm, and deionized polysilicate-free silica at 5%, all by weight.

| Table 5 | Ex. 21 | Ex. 22 | Ex. 23 | Ex. 24 | Ex. 25 | Ex. 26 |
|---|---|---|---|---|---|---|
| Silca (polysilicate free), wt % | 5 | 5 | 5 | 5 | 5 | 5 |
| Benzesulfonic acid, wt % | 1.0 | 1.0 | 1.0 | 1.0 | 1.0 | 1.0 |
| Potassium hydroxide, wt % | 0.41 | 0.41 | 0.41 | 0.41 | 0.41 | 0.41 |
| Benzotriazole, ppm | 100 | 100 | 100 | 100 | 100 | 100 |
| Zonyl FSP®, ppm | 0 | 500 | 1000 | 2000 | 500 | 2000 |
| Zonyl FSN®, ppm | 1000 | 1000 | 1000 | 1000 | 0 | 0 |
| H₂O₂ , wt% | 1.0 | 1.0 | 1.0 | 1.0 | 1.0 | 1.0 |
| pH before H₂O₂ | 10.4 | 10.4 | 10.4 | 10.4 | 10.4 | 10.4 |
| Cu RR 2 psi, Å/min | 87 | 115 | 105 | 93 | 92 | 68 |
| Ta RR 2 psi, Å/min | 420 | 416 | 445 | 445 | 473 | 466 |
| Black Diamond® RR 2 psi, Å/min | 60 | 100 | 239 | 246 | 415 | 392 |
| PETEOS RR 2 psi, Å/min | 279 | 280 | 274 | 293 | 297 | 297 |
| Selectivity, Ta/Black Diamond® | 7.0 | 4.1 | 1.8 | 1.8 | 1.13 | 1.18 |
| Selectivity, Cu/Black Diamond® | 1.45 | 1.15 | 0.43 | 0.3 | 0.22 | 0.17 |

A very broad range of Ta/Black Diamond® tuneability and copper /Black Diamond® tuneability can be achieved using between 0 and 2000 ppm each of a mixture of Zonyl FSN® and Zonyl FSP®. Again, as seen in several previous examples, slurries containing mixtures of Zonyl FSN® and Zonyl FSP® maintained constant copper rates (68 to 115 Å/min) and TEOS removal rates (274-297 Å/min). In Example 21, at 1000 ppm of the nonionic fluorosurfactant (Zonyl FSN®), the Ta/Black Diamond® selectivity was 7, and the Cu/Black Diamond® selectivity was 1.45. In Example 22, adding 500 ppm of the ionic fluorosurfactant Zonyl FSP® to the Example 21 slurry increased the removal rate of Black Diamond®, such that the Ta/Black Diamond® selectivity was reduced from 7 to 4, and the Cu/Black Diamond® selectivity was reduced from 1.45 to 1.15. This trend continued in Example 23. In Example 23, adding 1000 ppm of the ionic fluorosurfactant Zonyl FSP® to the Example 21 slurry increased the removal rate of Black Diamond®, such that the Ta/Black Diamond® selectivity was reduced from 7 to 1.8, and the Cu/Black Diamond® selectivity was reduced from 1.45 to 0.43. Surprisingly, the presence of the ionic fluorosurfactant Zonyl FSP® would at least partially negate the protective effect of the nonionic fluorosurfactant Zonyl FSN® on Black Diamond. This effect seemed to level out when equal weights of the ionic fluorosurfactant Zonyl FSP® and the nonionic fluorosurfactant Zonyl FSN® were present, and increasing the amount of the ionic fluorosurfactant Zonyl FSP® to 2000 ppm in Example 24 provided much the same selectivities as was shown with the slurry of Example 23, having only 1000 ppm of ionic fluorosurfactant Zonyl FSN®. Still, as seen in Example 25 and 26, if no nonionic fluorosurfactant Zonyl FSN® is present, very low Ta/Black Diamond® selectivity of about 1.15 and Cu/Black Diamond® selectivity of about 0.2 is obtained.

It was considered that the ethoxylated portion of the nonionic fluorosurfactant might be reactive with the hydrogen peroxide to form the free radical which eventually protects the low-k material such as Black Diamond®. Therefore, a series of experiments were performed to determine the effect of the fluorocarbon moiety (or segment) of the surfactant. In table 6, examples 27-32, a comparison of fluorinated surfactant such as Zonyl FSN® with a non-fluorinated surfactant such as Plurafac S505LF ® (which is an alcohol alkoxylate) on the removal rates of Black Diamond® at different concentration of H₂O₂ is tabulated. The results were quite surprising. The nonionic fluorinated surfactant Zonyl FSN® having an alkoxylated segment reduced the removal rates of Black Diamond® whereas nonionic non-fluorinated surfactant Plurafac S505LF® had no effect on the removal rates of Black Diamond® at concentrations of H₂O₂ between 1% and 5%.

| Table 6 | Ex. 27 | Ex. 28 | Ex. 29 | Ex. 30 | Ex. 31 | Ex. 32 |
|---|---|---|---|---|---|---|
| Silca (polysilicate free), wt % 5 | | 5 | 5 | 5 | 5 | 5 |
| Benzesulfonic acid, wt % | 1.0 | 1.0 | 1.0 | 1.0 | 1.0 | 1.0 |
| Potassium hydroxide, wt % | 0.41 | 0.41 | 0.41 | 0.41 | 0.41 | 0.41 |
| Benzotriazole (BTA), ppm | 100 | 100 | 100 | 100 | 100 | 100 |
| Plurafac S505LF®- t, ppm | 0 | 0 | 0 | 500 | 500 | 500 |
| Zonyl FSN®, ppm | 500 | 500 | 500 | 0 | 0 | 0 |
| H₂O₂, wt% | 1 | 3 | 5 | 1 | 3 | 5 |
| pH before H₂O₂ | 10.4 | 10.4 | 10.4 | 10.4 | 10.4 | 10.4 |
| Cu RR 2 psi, Å/min | 145 | 134 | 129 | 158 | 147 | 135 |
| Ta RR 2 psi, Å/min | 498 | 521 | 532 | 481 | 502 | 531 |
| Black Diamond® RR 2 psi, Å/min | 337 | 85 | 71 | 841 | 901 | 932 |
| PETEOS RR 2 psi, Å/min | 316 | 258 | 245 | 367 | 354 | 324 |
| Selectivity, Ta/Black Diamond® | 1.4 | 6.1 | 7.4 | 0.57 | 0.55 | 0.56 |
| Selectivity, Cu/Black Diamond® | 0.4 | 1.5 | 1.8 | 0.18 | 0.16 | 0.14 |

Use of nonionic fluorosurfactant, Zonyl FSN®, in a synergistic combination of with H₂O₂ controlled the removal rates of Black Diamond® with independent tune-ability with respect to copper, tantalum, and TEOS. This formulation also gives low defect counts. Previous Examples pertain to the use of anionic (preferably phosphate) fluorosurfactant such as Zonyl FSP® , and mixtures of Zonyl FSP® and a non-ionic fluorosurfactant such as Zonyl FSN®, in combination with H₂O₂ in slurry compositions to control the removal rates of Black Diamond®. Using Zonyl FSN®/H₂O₂, it is relatively straightforward to achieve independent tune-ability of Black Diamond® in the range of 330 Å/min to 50 Å/min with low defect counts on the copper/TEOS surface. A slurry including an anionic phosphate fluorosurfactant, e.g., Zonyl® FSP, further expands the range of Black Diamond® tune-ability above 400 Å/min, for example a tunable range between 50 Å/min and 450 Å/min. The wide operability window of the removal rate of low-k films such as carbon-doped oxide during chemical mechanical planarization of copper gives great flexibility to the manufacturing process. The anionic fluorosurfactants (Zonyl FSP®) and non-ionic flurosurfactants (Zonyl FSN®) have different polar groups, hence they adsorb differently on the Black Diamond surface during polishing, and this results in different removal rates of Black Diamond®, thus allowing wide window of removal rates. This invention allows independent tune-ability of Black Diamond® with respect to copper, tantalum, and silica or TEOS while maintaining a wide widow of removal rate of Black Diamond® between 50 Å/min to 450 Å/min.

Example 33 in Table 7 shows the effect of another surfactant, Zonyl®300, on the removal rates of Black Diamond® and tuneability ratios of Cu/Black Diamond® and Ta/Black Diamond®. Zonyl® FS300 (DuPont), which is a non-ionic fluorosurfactant free of organic solvent made of a perfluorinated hydrophobic tail and hydrophilic poly(ethylene oxide) head group.

| Table 7 | Comp Ex. 15 | Ex. 16 | Ex. 17 | Ex. 33 |
|---|---|---|---|---|
| Silca (polysilicate free), wt % | 5 | 5 | 5 | 5 |
| Benzesulfonic acid, wt % | 1.0 | 1.0 | 1.0 | 1.0 |
| Potassium hydroxide, wt % | 0.41 | 0.41 | 0.41 | 0.41 |
| Benzotriazole, ppm | 100 | 100 | 100 | 100 |
| Zonyl FSP®, ppm | | 500 | | 250 |
| Zonyl FSN®, ppm | | | 500 | |
| Zonyl I FS300® , ppm | | | | 500 |
| H₂O₂ wt % | 1.0 | 1.0 | 3.0 | 3.0 |
| pH before H₂O₂ | 10.4 | 10.4 | 10.4 | 10.4 |
| Cu RR 2 psi, Å/min | 77 | 88 | 57 | 71 |
| Ta RR 2 psi, Å/min | 482 | 325 | 329 | 347 |
| Black Diamond® RR 2 psi, Å/min | 592 | 398 | 33 | 63 |
| PETEOS RR 2 psi, Å/min | 291 | 144 | 180 | 167 |
| Selectivity, Ta/Black Diamond® | 0.81 | 0.81 | 9.9 | 5.3 |
| Selectivity, Cu/Black Diamond® | 0.13 | 0.22 | 1.7 | 1.1 |

The invention has been illustrated by these embodiments, but is not limited to the various examples contained herein.

## Claims

1. A method of chemical mechanical planarization comprising: movably contacting a substrate, having a surface which comprises copper, a low-k dielectric material, and a barrier material, with a polishing pad and a polishing composition disposed between the polishing pad and the surface, said polishing composition comprising between 0.5% and 9% by weight of a per-type oxidizer and between 10 ppm and 4000 ppm by weight of a non-ionic fluorosurfactant.

2. The method of claim 1 wherein the non-ionic fluorosurfactant reduces the removal rate of the low-k material compared to the removal rate of the low-k material during polishing with an otherwise identical slurry but not having a non-ionic fluorosurfactant.

3. The method of any preceding claim wherein the per-type oxidizer is a peroxide.

4. The method of any preceding claim wherein the polishing composition further comprises between 1 % to 10% by weight of colloidal silica abrasive.

5. The method of any preceding claim wherein the pH of the polishing composition is greater than 8.

6. The method of any preceding claim wherein the polishing composition further comprises between 50 and 400 ppm by weight of a corrosion inhibitor.

7. The method of any preceding claim wherein the polishing composition comprises colloidal silica abrasive that is substantially free of soluble polymeric silicates.

8. The method of any preceding claim wherein the polishing composition further comprises a polyvinylpyridine-N-oxide polymer or between 0.2% and 3% by weight of an aromatic sulfonic acid compound, which increases the removal rate of Ta.

9. The method of any one of Claim 1-7 wherein the polishing composition further comprises an aromatic sulfonic acid oxidizer compound in an amount between 0.2% to 3% by weight.

10. The method of Claim 8 or 9 wherein the aromatic sulfonic acid oxidizer is present in an amount between 0.5% and 1.5% by weight.

11. The method of any one of Claims 8 to 10 wherein the aromatic sulfonic acid oxidizer is benzenesulfonic acid.

12. The method of any preceding claim wherein the non-ionic fluorosurfactant is present in the polishing composition in an amount which does not significantly affect the removal rates of copper, silica, and the barrier layer material.

13. The method of any preceding claim wherein the non-ionic fluorosurfactant has the following structure:
(R_{f})(R₁O)ₓR_{b}
where: R_{f} = X(CX₂)y, where X is F or any combination of H and F provided that at least a portion of the X atoms in the surfactant are F, and where y is between 1 to 18; R₁O is independently CH₂CH₂O-, CH₂CH₂CH₂O- , or CₐH₂ₐO- , where the number of carbon atoms "a" is between 3 and 8, or any combination of the above, and where x = 1 to 26; and R_{b} is H or a straight, branched, or ringed alkane, alkene, alkyne, alcohol, or fatty acid having between 1 and 18 carbon atoms.

14. The method of Claim 13 wherein at least three quarters of the X atoms in the R_{f} segment are F; the average y in the R_{f} segment is between 6 and 12; and (R₁O)ₓ comprises at least one block of CH₂CH₂O-segments where x is at least 4.

15. The method of Claim 14 wherein the average x is between 5 to 20.

16. The method of any preceding Claim wherein the pH of the polishing composition is between 9 and 12, wherein the per-type oxidizer is a peroxide, and the low-k material is a carbon-doped oxide, the concentration of the non-ionic fluorosurfactant is greater than 250 ppm, and the removal rate of the carbon-doped oxide is between 50 A/min and 350 A/min.

17. The method of any one of Claims 1 to 15 wherein the polishing composition further comprises an anionic phosphate fluorosurfactant in an amount between 10 ppm and 3000 ppm, the per-type oxidizer is a peroxide, the low-k material is a carbon-doped oxide, the concentration of the non-ionic fluorosurfactant is greater than 250 ppm, and the removal rate of the carbon-doped oxide is between 50 Å/min and 450 Å/min when measured at 13.8 kPa (2 psi) polishing pressure.

18. The method of any one of Claims 1 to 15 wherein the low-k material is a carbon-doped oxide having a dielectric constant below 2.4, the per-type oxidizer is a peroxide, the concentration of the non-ionic fluorosurfactant is greater than 250 ppm, and the non-ionic fluorosurfactant is a block copolymer comprising a block of polyoxypropylene and a block of polyoxyethylene.

19. The method of any one of Claims 1 to 15 wherein: the substrate surface comprises silica; the polishing composition comprises colloidal silica, benzenesulfonic acid, and between 250 ppm and 2000 ppm of the non-ionic fluorinated surfactant; the per-type oxidizer is hydrogen peroxide; and the removal rate of copper is between 50 and 150 A/min, the removal rate of silica is between 150 and 250 A/min, the removal rate of tantalum is 200 to 400 A/min, and the removal rate of carbon-doped low-k material is between 200 and 400 A/min, where each removal rate is measured at 13.8 kPa (2 psi) polishing pressure.

20. A polishing slurry for chemical mechanical polishing of substrates comprising both copper and a low-k material, the polishing composition comprising water, between 0.5% and 9% by weight of a peroxide, and between 10 ppm and 4000 ppm of a non-ionic fluorosurfactant, between 1 % to 10% by weight of colloidal silica abrasive, and has a pH greater than 8.

21. The polishing slurry of Claim 20, wherein the polishing slurry is as further defined in any one of Claims 2 or 6 to 20.

22. A method of chemical mechanical planarization comprising: movably contacting a substrate having a surface which comprises copper, a low-k dielectric material, and a barrier material with a polishing pad and a polishing composition disposed between the polishing pad and the surface, said polishing composition comprising between 0.5% and 9% of a per-type oxidizer and between 10 ppm and 4000 ppm of an anionic phosphate fluorosurfactant and has a pH between 9 and 12, wherein the anionic phosphate fluorosurfactant tunes the removal rate of the low-k material.

23. The method of Claim 22 wherein the polishing composition further comprises colloidal silica abrasive and a corrosion inhibitor, wherein the per-type oxidizer is a peroxide, the low-k material is a carbon-doped oxide, the concentration of the anionic phosphate fluorosurfactant is greater than 250 ppm, and the removal rate of the carbon-doped oxide is between 50 A/min and 450 A/min.

24. The method of Claim 22 or 23 where the polishing composition further comprises benzenesulfonic acid and a non-ionic fluorosurfactant.

25. The method of any one of Claims 22 to 24 wherein the polishing composition further comprises colloidal silica abrasive that is substantially free of soluble polymeric silicates.
